Europäisches Patentamt

European Patent Office

Office européen des brevets

(11) Numéro de publication: **0 214 011**
**A1**

## DEMANDE DE BREVET EUROPEEN

(21) Numéro de dépôt: **86401680.3**

(22) Date de dépôt: **28.07.86**

(51) Int. Cl.⁴: **H 03 M 1/30**
**G 01 D 5/245**

(30) Priorité: **30.07.85 FR 8511611**

(43) Date de publication de la demande:
**11.03.87 Bulletin 87/11**

(84) Etats contractants désignés:
**AT BE CH DE GB IT LI LU NL SE**

(71) Demandeur: **M.C.B.**
**11, rue Pierre Lhomme**
**F-92400 Courbevoie (FR)**

(72) Inventeur: **Taillebois, Jacques**
**Résidence Brigitte 23, rue Egisoires**
**F-78370 Plaiser (FR)**

**Gambs, Paul**
**132, Chemin du Petit Bois**
**F-69130 Ecully (FR)**

**Renaud, Jean-Marie**
**17, rue Pierre Brossolette**
**F-92400 Courbevoie (FR)**

(74) Mandataire: **Lecca, Jean et al**
**CABINET PLASSERAUD 84, rue d'Amsterdam**
**F-75009 Paris (FR)**

(54) **Lecteur de code optique incrémental, notamment du type entièrement intégré.**

(57) Le dispositif comprend, d'une part, un ensemble 1 de lecture proprement dit avec, pour chacune des pistes de l'élément codé, une paire de photodiodes, un amplificateur différentiel recevant les sorties des photodiodes et un trigger connecté à la sortie de l'amplificateur et, d'autre part, un ensemble électronique Z, à portes logiques, "OU exclusif" 8a à 8f, ET 9a à 9h et 10a à 10z, OU 11a à 11g et 12a à 12c, ET 14a et 14b et OU 15, recevant les sorties des triggers pour les voies V1 à V14 et débitant sur des sorties S1, S2, Ss et To.

FIG.1.

## Description

"LECTEUR DE CODE OPTIQUE INCREMENTAL, NOTAMMENT DU TYPE ENTIEREMENT INTEGRE"

La présente invention concerne un lecteur de code optique incrémental, porté notamment par un disque à pistes codées, la lecture ayant lieu avantageusement par diascopie, c'est-à-dire par lecture différentielle des zones transparentes et des zones opaques du disque.

On sait qu'un tel lecteur incrémental comprend -en combinaison avec un disque comportant plusieurs pistes concentriques chacune avec une succession de zones opaques et de zones transparentes fines alternantes - au moins une source de lumière, apte à éclairer l'ensemble des pistes, et un ensemble lecteur de code proprement dit, qui émet des impulsions électriques représentant finalement la position angulaire incrémentale relative de deux éléments d'un ensemble mobiles l'un par rapport à l'autre, le disque étant porté par l'un de ces éléments, ainsi qu'une impulsion, dite "Top 0" qui permet d'initialiser la position relative angulaire.

Les lecteurs de code optique incrémental sont de plus en plus utilisés, une de leurs applications (à laquelle s'applique particulièrement l'invention) étant celle de détermination de la position angulaire incrémentale des éléments mobiles d'un robot, en prévoyant, dans ce cas, un dispositif de lecture par élément mobile.

Bien que l'invention s'applique particulièrement à la lecture d'un disque codé par diascopie, c'est-à-dire par transparence, elle peut également s'appliquer à la lecture d'un disque codé par réflexion, et également à la lecture d'une réglette codée en déterminant alors, non pas une position angulaire, mais un déplacement linéaire relatif entre deux éléments, dont l'un est mobile en translation par rapport à l'autre, la réglette étant portée par un de ces deux éléments.

Dans la suite de la présente description on se limitera au cas de la lecture incrémentale par diascopie d'un disque codé comportant plusieurs pistes concentriques.

Classiquement, un dispositif de lecture incrémental d'un disque codé comprend

d'une part, au moins une source de lumière constituée soit par une lampe à filament émettant de la lumière dans un spectre large qui comprend le visible et le proche infrarouge (le proche infrarouge étant la zone de sensibilité maximale pour les photodétecteurs, notamment au silicium), la lampe à filament éclairant, à travers un système optique approprié, l'ensemble des pistes du disque, soit par un ensemble de diodes émettrices de lumière, généralement dans le proche infrarouge (dans la bande de 0,8 à 0,9 microns);

d'autre part, un ensemble lecteur de code proprement dit, qui coopère avec le disque codé et la source de lumière, ou les sources de lumière, et qui comprend d'abord une série de photodétecteurs en nombre égal au nombre de pistes, ces photodétecteurs étant constitués notamment par des photodiodes ou des phototransistors qui se présentent soit sous forme de composants discrets, soit disposés dans un boîtier commun; dans les deux cas le nombre des photodétecteurs est égal au nombre des diodes émettrices de lumière lorsque la source de lumière est constituée par de telles diodes.

Les photodétecteurs de la technique antérieure débitent des signaux très faibles et de ce fait ils sont suivis par des amplificateurs, notamment par des amplificateurs opérationnels du commerce constitués par des circuits intégrés avec des composants discrets câblés sur un circuit imprimé; ou bien on met en oeuvre des circuits hybrides ou "prédiffusés" spécifiques comportant en général autant d'amplificateurs qu'il y a de pistes codées et donc de photodétecteurs (ci-après on parlera de voies de lecture, à savoir une voie par piste du disque codé).

Dans chaque voie, l'amplificateur est suivi classiquement par un circuit de mise en forme, constitué en général par un trigger du type bascule de Schmitt, donnant en sortie des impulsions à front raide en réponse à chaque zone transparente de la piste correspondant à la voie en question. Avantageusement on dispose dans un même boîtier l'ensemble des bascules de Schmitt, ou même, plus avantageusement encore, l'ensemble des amplificateurs et l'ensemble des bascules de Schmitt, soit suivant la technique hybride, soit suivant la technique des circuits prédiffusés. Il faut prévoir en outre pour chaque bascule de Schmitt, c'est-à-dire pour chaque voie, un élément de réglage destiné à ajuster le seuil de basculement de la bascule afin d'assurer, en dépit des variations de sensibilité des photodétecteurs, un bon fonctionnement de chaque voie et une bonne précision de la commutation des unités électroniques subséquentes.

En effet il est nécessaire, pour un grand nombre d'applications des dispositifs de lecture de code, d'effectuer des traitements logiques avant transmission des informations obtenues, pour chaque voie, par une chaîne photodétecteur-amplificateur-bascule de Schmitt.

Notamment on prévoit en général des moyens de calibrage du Top 0 qui assurent la constance de l'instant initial de chaque Top, donc le calage exact du début de la lecture incrémentale.

La transmission des informations à partir du dispositif de lecture est effectuée classiquement en utilisant, comme circuits d'interface, des émetteurs et des récepteurs de lignes qui sont constitués par des boîtiers du commerce.

Enfin la tension d'alimentation est réglée et filtrée à l'intérieur du dispositif de lecture et de la source de lumière.

Il est en outre nécessaire, dans la plupart des cas, de compenser les fluctuations ou les dérives de la source de lumière unique ou des sources de lumière pour assurer un bon fonctionnement de l'ensemble dans une large plage de températures.

L'ensemble de l'alimentation, de sa régulation et de sa filtration, d'une part, et de la compensation des fluctuations de la ou des sources de lumière, d'autre part, est réalisé classiquement au moyen de composants disponibles dans le commerce.

On comprend aisément que le dispositif de lecture incrémental qui vient d'être décrit ci-dessus exige, dans la construction habituelle, un grand nombre de composants qui, une fois câblés sur un circuit imprimé, occupent un volume important et coûtent relativement cher, et ceci en présentant une fiabilité limitée.

On a proposé, pour pallier ces inconvénients, de réaliser une hybridation de la partie électronique (amplificateurs, bascules de Schmitt, moyens logiques), ou bien de constituer la partie électronique en plusieurs grands blocs fonctionnels, en réalisant chacun de ces blocs sous la forme d'un circuit prédiffusé, ou bien encore d'effectuer un panachage d'hybridation et ce circuits prédiffusés. Ces trois types de solutions permettent de réduire l'encombrement et d'améliorer la fiabilité, mais ne réduisent pratiquement pas le prix de l'ensemble du dispositif de lecture du code incrémental (source de lumière et dispositif de lecture proprement dit associé).

La présente invention vise à améliorer simultanément les trois facteurs précités (encombrement, fiabilité et coût) des dispositifs de lecture connus, en réduisant l'encombrement, en augmentant la fiabilité et en réduisant le coût, et ceci en permettant par ailleurs de tester l'ensemble du dispositif de lecture sans augmenter la complexité du système et/ou de choisir la résolution du dispositif de lecture de code optique incrémental par simple programmation sans changer le disque codé.

Pour ce faire, l'invention vise à réaliser les différents composants optoélectroniques (photodétecteurs), analogiques (amplificateurs, etc.), logiques (bascules, portes, etc.) et d'interface (portes 3 états, etc.), de manière à pouvoir intégrer ces composants sur une puce, ou éventuellement un nombre réduit de puces de silicium, en prévoyant en outre sur cette ou ces puces des moyens permettant de tester l'ensemble de lecture proprement dit et/ou des moyens permettant de choisir la résolution du dispositif de lecture et éventuellement des moyens réalisant d'autres fonctions.

On réduit ainsi considérablement la dimension et le côut du dispositif de lecture, tout en augmentant la fiabilité et en réduisant les fluctuations.

La présente invention a pour objet un dispositif de lecture de code optique incrémental - destiné à coopérer avec un élément en mouvement relatif par rapport à ce dispositif de lecture et comportant une première série de n pistes codées avec une succession de zones élémentaires de deux types de retransmission de lumière reçue et une seconde série de n pistes, chacune de ces dernières pistes étant codée complémentairement à une des pistes de la première série - qui comprend

une source de lumière pour éclairer les pistes des deux séries, et

des moyens de détermination d'éclairement pour déterminer si de la lumière est ou non retransmise par une zone élémentaire observée de chacune des pistes,

ce dispositif de lecture étant caractérisé en ce que les moyens de détermination d'éclairement, qui sont portés par 1 à p puces (p étant un nombre entier petit), comportent en combinaison :

- d'une part, pour chacune des pistes de l'élément codé,une paire de photodiodes, un amplificateur différentiel dont les deux entrées reçoivent les signaux émis par les deux photodiodes, un trigger donnant un front avant raide aux signaux reçus de la sortie de l'amplificateur différentiel; et

- d'autre part, un ensemble électronique à portes logiques recevant les sorties desdits triggers et débitant sur au moins trois sorties les signaux représentatifs de position pour deux voies décalées de $\pi/2$ et un Top calibré.

Dans les modes de réalisation préférés, l'élément porteur de code est un disque et la lecture des zones opaques ou transparentes de celui-ci est effectuée par diascopie, c'est-à-dire par lumière transmise ou non transmise à travers les zones respectivement transparentes et opaques du disque.

Avantageusement :

- l'amplificateur différentiel est en réalité constitué par deux amplificateurs en parallèle, recevant chacun la sortie d'une des deux photodiodes de la paire de photodiodes accouplées, et par un comparateur dont les deux entrées reçoivent chacune la sortie d'un des deux amplificateurs précités disposés en parallèle;

- on prévoit un décalage d'amplitude, dans le basculement provoqué par la partie montante, d'une part, et la partie descendante, d'autre part, du signal sortant de l'amplificateur différentiel, c'est-à-dire une hystérésis du comparateur, dans le mode de réalisation préféré de cet amplificateur différentiel;

- le dispositif de lecture comporte des moyens pour envoyer, sur les photodiodes ou les entrées des amplificateurs différentiels, des signaux aptes à simuler, sur la sortie des diodes ou l'entrée des amplificateurs respectivement, à volonté le niveau de bit "0" ou "1";

- l'ensemble électronique de portes logiques débité également sur une quatrième sortie un signal à fréquence maximale représentatif de la vitesse de déplacement relatif de l'élément en mouvement relatif par rapport au dispositif de lecture;

- le dispositif de lecture comporte, d'une part, dans l'ensemble de portes électroniques, des portes supplémentaires permettant par combinaison logique d'engendrer des pistes fictives en plus des pistes prévues sur l'élément en mouvement relatif, et, d'autre part, des moyens pour commander ces portes supplémentaires afin de rendre opérationnelles soit les pistes réelles de cet élément, soit des pistes fictives sélectionnées parmi les pistes fictives ainsi engendrables.

L'invention pourra, de toute façon, être bien comprise à l'aide du complément de description qui suit, ainsi que des dessins ci-annexés, lesquels complément et dessins sont, bien entendu, donnés surtout à titre d'indication.

La figure 1 représente schématiquement, sous forme de blocs, un dispositif de lecture doté des perfectionnements selon l'invention, complètement intégrable, pour 14 voies, la source de lumière n'étant pas représentée.

La figure 2 représente une des voies de lecture proprement dite avec un comparateur suivi d'un trigger.

La figure 3 illustre des signaux composés entrant dans le comparateur de la figure 2.

La figure 4 illustre des impulsions sortant du trigger ou bascule de la figure 3.

Les figures 5, 6 et 7 représentent les tables de vérité correspondant au schéma électronique de la figure 1, respectivement pour les deux voies décalées de $\pi/2$, le Top 0 et la voie la plus rapide ou voie tachymétrique.

La figure 8 illustre les signaux électriques en différents points du schéma de la figure 1, avant et après traitement dans les portes logiques.

Les figures 9, 10 et 11 sont des tableaux représentant les résolutions de trois disques codés n° I, n° II et n° III, respectivement, aptes à coopérer avec le lecteur incrémental selon l'invention.

Les figures 12, 13 et 14 enfin, représentent schématiquement la résolution et la position des différentes voies pour les disques codés n° I, II et III respectivement des figures 9, 10 et 11.

Selon l'invention et plus spécialement selon celui de ses modes d'application, ainsi que selon ceux des modes de réalisation de ses diverses parties, auxquels il semble qu'il y ait lieu d'accorder la préférence, se proposant, par exemple, de réaliser un dispositif de lecture de code optique, notamment du type entièrement intégré, on s'y prend comme suit ou d'une manière analogue.

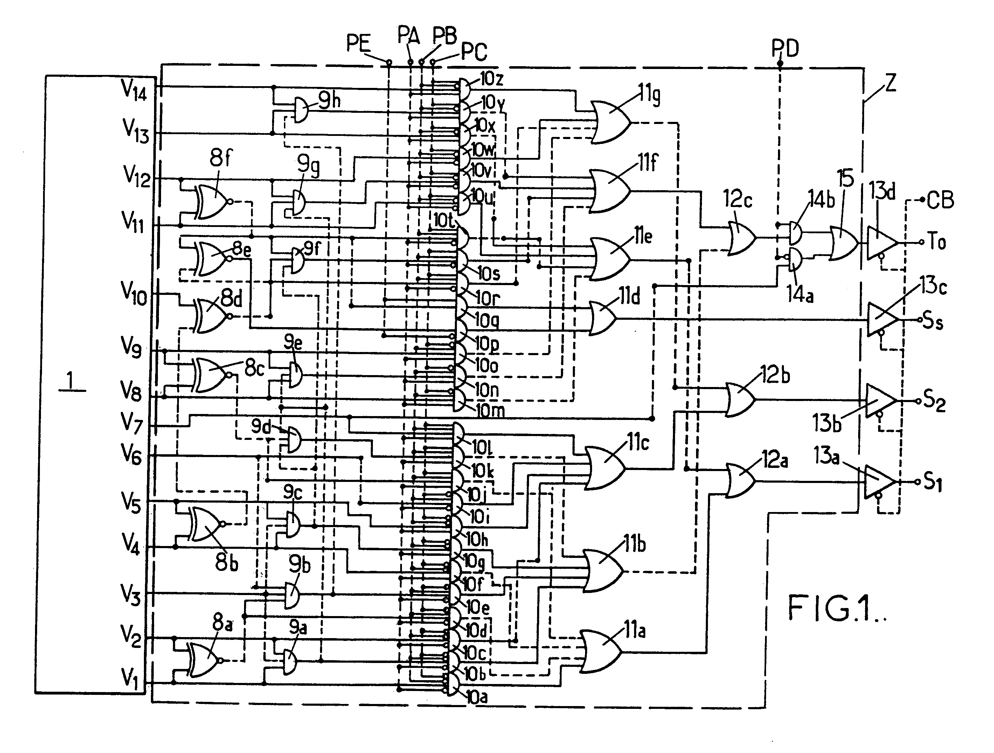

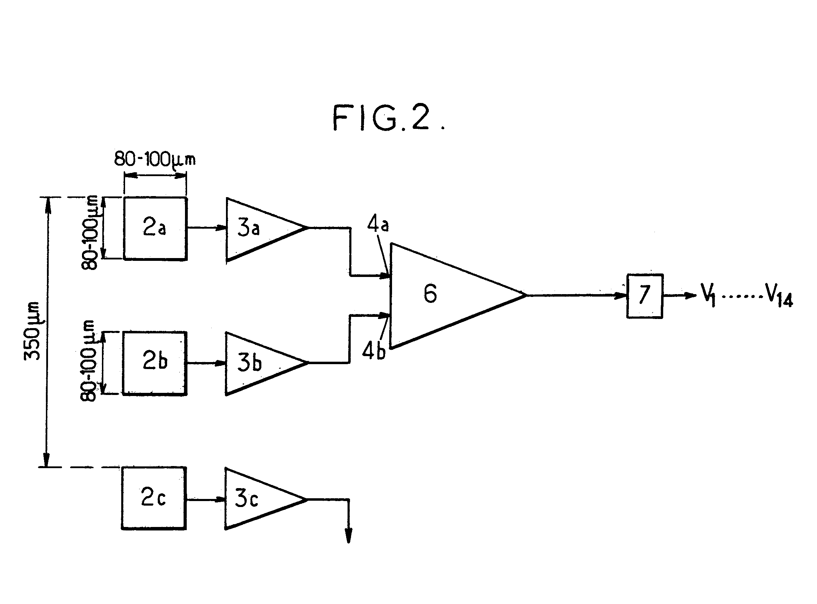

En se référant tout d'abord aux figures 1 et 2, qui illustrent respectivement l'ensemble et une partie d'un dispositif de lecture, entièrement intégré, pour 14 voies, on voit que ce dispositif comporte un système 1 avec 14 voies de lecture V1 à V14, une de ces voies étant détaillée sur la figure 2.

Chaque voie de lecture (figure 2) comporte tout d'abord une paire de photodiodes 2a, 2b de 80 à 100 microns au carré, travaillant en différentiel, l'une des diodes 2a lisant une des pistes codées (de la première série de pistes), tandis que l'autre diode 2b lit une piste associée (de la seconde série de pistes) portant des zones complémentaires aux zones correspondantes de la première piste.

La sortie de chacune des diodes 2a, 2b est amplifiée dans un amplificateur 3a, 3b, et les sorties des deux amplificateurs sont connectées chacune à une entrée 4a, 4b d'un comparateur 6.

La sortie du comparateur 6, qui est un signal alternatif, est traitée par un trigger 7 du type bascule de Schmitt dont la sortie est constituée par un signal rectangulaire.

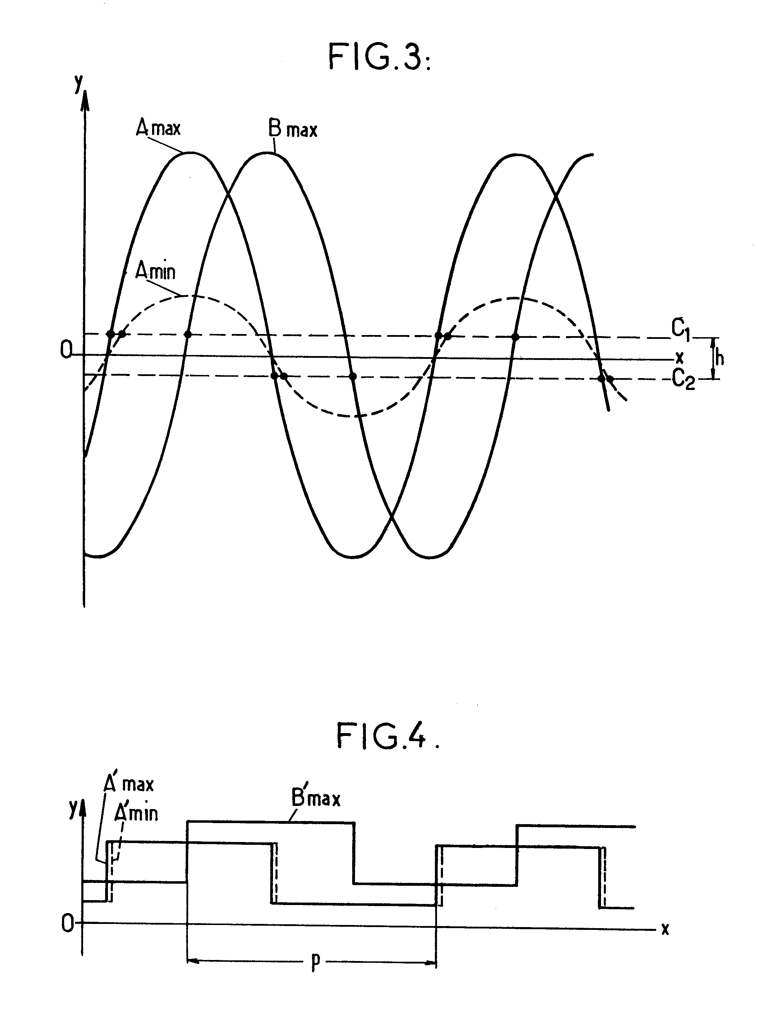

Le comparateur 6 comporte une hystérésis pour éviter les oscillations au voisinage de l'équilibre, comme cela va être expliqué avec référence aux figures 3 et 4.

Toutefois pour en terminer avec la description de la figure 2, on signalera que sur celle-ci on a représenté une partie d'une voie voisine, à savoir la photodiode 2c et l'amplificateur 3c de celle-ci, et on a porté les distances approximatives concernant les photodiodes pour montrer le faible encombrement des quatorze paires de photodiodes. On voit en particulier que la largeur d'une voie est de 350 microns.

Enfin on peut prévoir une unité de test (non représentée) apte à agir sur la partie initiale des voies V1 à V14 pour commander la simulation des bits "1" ou "0" aux entrées des amplificateurs, tels que 3a et 3b de la figure 2, ou bien sur la sortie des diodes, telles que 2a et 2b de la figure 2.

Sur la figure 3 on a illustré deux signaux d'amplitudes extrêmes, A max et A min, sortant de l'amplificateur différentiel 6 et représentant la sortie d'une voie de lecture (par exemple la voie 1). Le signal B max représente la sortie, à amplitude maximale, de la voie décalée de $\pi/2$ par rapport au signal A max (ou A min).

L'hystérésis du trigger est représentée par la variation h d'amplitude entre les points de basculement du trigger 7 à la montée (horizontale C1) et à la descente (horizontale C2). Ces deux horizontales C1 et C2 sont illustrées en traits interrompus de part et d'autre de l'axe Ox des abscisses, les amplitudes étant portées suivant l'axe des ordonnées Oy. On a indiqué par des points le croisement des courbes A max, A min et B max avec l'horizontale C1 à la montée et avec l'horizontale C2 à la descente. Ce sont les points de basculement du trigger 7.

Les signaux représentés sur la figure 3 constituent les entrées des triggers ou bascules de Schmitt 7 de chaque voie, alors que sur la figure 4 on a représenté les sorties de ces triggers, sorties qui sont constituées par des signaux rectangulaires. A la sortie d'un trigger, A max est devenu A'max, tandis que A min est devenu A'min. On s'aperçoit aisément que le signal d'amplitude maximale A max et le signal d'amplitude minimale A min sont transformés en signal A'max et signal A'min respectivement, avec simplement un très léger décalage dans le temps, le rapport cyclique pour A'max et A'min étant indépendant de l'amplitude du signal d'entrée comprise entre A min et A max.

Sur la figure 4 on a également illustré le signal B'max de sortie du trigger 7 correspondant au signal d'entrée B max, B'max étant décalé de $\pi/2$ par rapport à A'max ou A'min. Sur cette figure la durée d'une période est représentée en p.

On revient maintenant à la description de la figure 1 dont l'ensemble 1 est constitué par 14 voies V1, V2, V3, V13, V14 identiques chacune à la voie 2a-3a, 2b-3b, 6, 7, de la figure 2.

Un ensemble électronique Z à portes logiques est disposé entre les sorties des voies V1 à V14 de l'ensemble 1 de lecture proprement dit et quatre sorties S1, S2, Ss et To, à savoir :

- les sorties S1 et S2 prévues pour débiter des signaux de sortie pour deux voies décalées de $\pi/2$, afin de pouvoir préciser le sens de rotation du disque codé par la détermination, parmi les signaux décalés de $\pi/2$, du signal qui est en avance sur l'autre;

- la sortie Ss relative à une voie spéciale, déduite des voies V1 à V14, comme indiqué ci-dessous, cette voie spéciale étant à vitesse ou fréquence maximale et donnant une information tachymétrique sur la vitesse de rotation relative du disque codé; et
- la sortie To prévue pour débiter un signal calibré de Top 0.

Les sorties S1, S2, Ss et To sont du type à trois états et elles sont commandées à partir d'un plot CB.

L'ensemble électronique Z comporte des portes ET illustrées par un demi-cercle à base verticale, des portes OU représentées par des écussons, des portes "OU exclusif" représentées par des écussons avec un double trait à gauche et des portes NON (réalisant la fonction inversion) représentées par des petits cercles disposés soit à l'entrée, soit à la sortie d'une des portes de type précédent.

On rappelle que ces portes comportent une seule sortie qui est alimentée :
- pour les portes ET, lorsque toutes les entrées sont simultanément alimentées;
- pour une porte OU, lorsque au moins une entrée est alimentée;
- pour une porte "OU exclusif", lorsque une et une seule entrée est alimentée;
- pour une porte NON (fonction inversion), lorsque l'entrée unique n'est pas alimentée.

Cet ensemble électronique Z de portes logiques sert d'abord à alimenter, à partir des sorties V1 à V14 de l'ensemble 1 de lecture proprement dite, les sorties S1, S2, Ss et To.

Il sert ensuite à engendrer des pistes fictives (non gravées sur le disque codé) en combinant logiquement les sorties de pistes effectivement gravées, ce qui permet entre autres de doubler la résolution limite par rapport à la résolution qui peut être raisonnablement gravée sur un disque codé et d'économiser le nombre de voies de lecture.

Il sert également à calibrer le Top 0 pour chaque résolution réelle ou fictive.

On notera que, pour faciliter la lecture de la figure 1, certaines des connexions entre portes sont en traits pleins et certaines en traits interrompus (dans le circuit intégré ces deux types de connexions se tournent par exemple dans des plans différents).

On va maintenant expliciter la nature et les interconnexions des portes de la figure 1.

Six portes "OU exclusif" 8a, 8b...8e, 8f, chacune à deux entrées, sont attaquées par les voies sortant de l'ensemble 1 ou par les sorties de portes 8 suivantes : V1 et V2 pour 8a, V4 et V5 pour 8b, V8 et V9 pour 8c, V10 et la sortie de 8b pour 8d, la sortie de 8d et la sortie de 8f pour 8e, enfin V11 et V12 pour 8e.

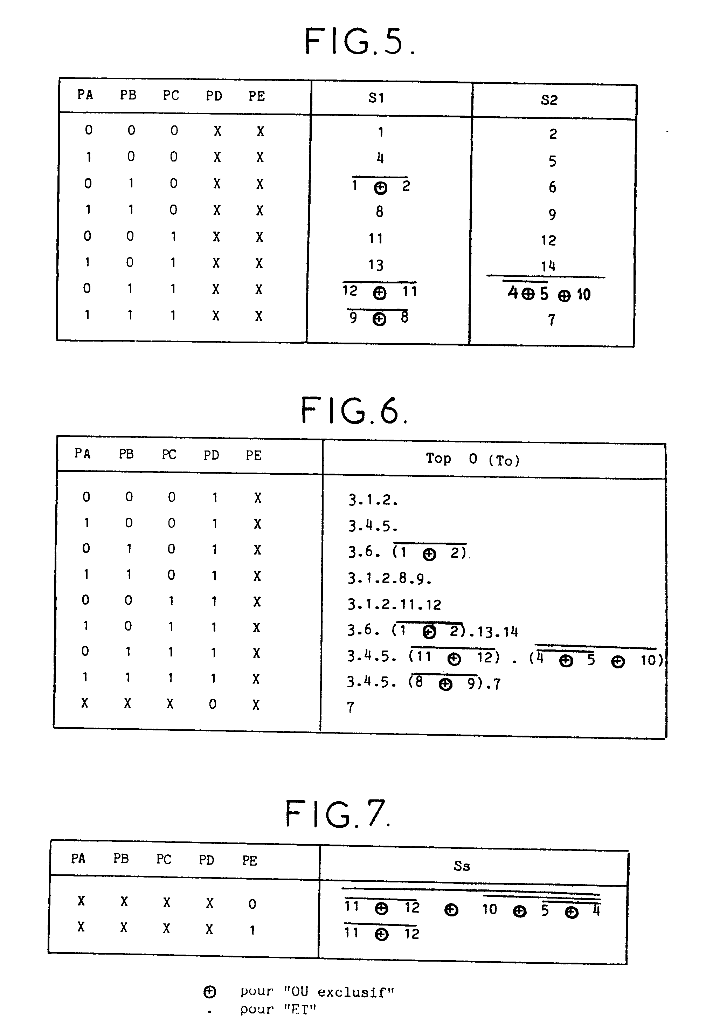

On remarquera que des cercles figurent à la sortie de six portes "OU exclusif" 8a à 8f de manière à réaliser donc la fonction "OU exclusif inversée" ou coïncidence, notée $X \odot Y$. , pour des entrées X et Y, dans les tables de vérité des figures 5 à 7 dont il sera fait état ci-après, le signe $\oplus$ représentant la fonction "OU exclusif".

Huit portes ET 9a, 9b...9g, 9h, chacune à trois entrées, sont attaquées par les voies V1 à V14 ou les sorties d'autres portes des séries 8 (après inversion) et 9.

En particulier :
- la porte 9a reçoit V1, V2 et V3;
- la porte 9b reçoit V3, V6 et la sortie de la porte 8a (après inversion);
- la porte 9c reçoit V3, V4 et V5;
- la porte 9d reçoit les sorties des portes 8c, (après inversion), 9a et 9c;
- la porte 9e reçoit V8, V9 et la sortie de la porte 9a;
- la porte 9f reçoit les sorties des portes 8d, (après inversion), 8f (après inversion) et 9c;
- la porte 9g reçoit V11, V12 et la sortie de la porte 9a; et
- la porte 9h reçoit V13, V14 et la sortie de la porte 9b.

Vingt-six portes ET 10a, 10b...10y, 10z, chacune à 4 entrées (sauf les portes 10p et 10q à 2 entrées), reçoivent, d'une part, une voie V1 à V14 ou une sortie de porte des séries 8 (après inversion) et 9 et, d'autre part, trois ordres (ou seulement un ordre pour les portes 10p et 10q) à partir des trois plots PA, PB et PC de programmation de la résolution (ou à partir du plot PE qui programme la sortie de fréquence maximale vers la sortie Ss pour les portes 10p et 10q).

On notera que certaines entrées de portes ET de la série 10 comportent un symbole d'inhibition (petit cercle).

Dans le tableau ci-après des entrées de ces portes de la série 10 on a surligné les arrivées sur les entrées inhibées.

| porte | entrées |
|---|---|
| 10a | V1; $\overline{PA}$, $\overline{PB}$, $\overline{PC}$ |
| 10b | sortie de 9a; $\overline{PA}$, $\overline{PB}$, $\overline{PC}$ |
| 10c | V2; $\overline{PA}$, $\overline{PB}$, $\overline{PC}$ |
| 10d | sortie inversée de 8a; $\overline{PA}$, PB, $\overline{PC}$ |
| 10e | sortie de 9b; $\overline{PA}$, PB, $\overline{PC}$ |
| 10f | V4; PA, $\overline{PB}$, $\overline{PC}$ |
| 10g | sortie de 9c; PA, $\overline{PB}$, $\overline{PC}$ |
| 10h | V5; PA, $\overline{PB}$, $\overline{PC}$ |
| 10i | V6; $\overline{PA}$, PB, $\overline{PC}$ |
| 10j | sortie inversée de 8c; PA, PB, PC |
| 10k | sortie de 9d; PA, PB, PC |
| 10l | V7; PA, PB, PC |
| 10m | V8; PA, PB, $\overline{PC}$ |
| 10n | sortie de 9e; PA, PB, $\overline{PC}$ |
| 10o | V9; PA, PB, $\overline{PC}$ |
| 10p | sortie inversée de 8e; $\overline{PE}$ |
| 10q | sortie inversée de 8f; PE |
| 10r | sortie inversée de 8d; $\overline{PA}$, PB, PC |
| 10s | sortie de 9f; $\overline{PA}$, PB, PC |
| 10t | sortie inversée de 8f; $\overline{PA}$, PB, PC |
| 10u | V11; $\overline{PA}$, $\overline{PB}$, PC |
| 10v | sortie de 9g; $\overline{PA}$, $\overline{PB}$, PC |
| 10w | V12; $\overline{PA}$, $\overline{PB}$, PC |
| 10x | V13; PA, $\overline{PB}$, PC |
| 10y | sortie inversée de 9h; PA, $\overline{PB}$, PC |
| 10z | V14; PA; $\overline{PB}$, PC |

Sept portes OU 11a, 11b...11f, 11g, chacune à 4 entrées (sauf la porte OU 11d qui n'a que 2 entrées), combinent les sorties des portes ET de la série 10 comme suit :
la porte 11a reçoit les sorties des portes 10a, 10d, 10f et 10j;
la porte 11b reçoit les sorties des portes 10b, 10e, 10g et 10k;
la porte 11c reçoit les sorties des portes 10c, 10h, 10i et 10l;
la porte 11d reçoit les sorties des portes 10p et 10q;

la porte 11e reçoit les sorties des portes 10m, 10t, 10u et 10x;

la porte 11f reçoit les sorties des portes 10n, 10s, 10v et 10y;

la porte 11g reçoit les sorties des portes 10o, 10r, 10w et 10z.

On notera qu'une sortie de porte ET de la série 10 alimente une entrée et une seule des portes OU de la série 11 (il y a, d'une part, 26 sorties de portes ET de la série 10 et, d'autre part, 26 entrées de portes OU de la série 11, à savoir six portes OU à quatre entrées et une porte OU à deux entrées 4 x 6 + 2 = 26).

Les sorties de six portes OU 11a, 11b, 11c, 11e, 11f, 11g, parmi les sept portes OU de la série 11, sont combinées par trois portes OU 12a, 12b, 12c à deux entrées chacune.

La porte 12a reçoit les sorties des portes 11a et 11e, la porte 12b les sorties des portes 11c et 11g et la porte 12c les sorties des portes 11b et 11f.

Les sorties des portes 12a et 12b sont connectées aux sorties S1 et S2 respectivement par des amplificateurs 13a et 13b respectivement, commandables à partir du plot CB, tandis que la porte 11d alimente à travers l'amplificateur 13c, également commandable a partir du plot CB, la sortie Ss.

L'ensemble électronique Z de portes logiques comprend finalement deux portes ET 14a et 14b à deux entrées chacune, dont les sorties sont combinées dans une porte OU 15 à deux entrées.

La porte 14a reçoit, d'une part, la voie V7 et, d'autre part, un signal assurant la programmation du Top 0 à partir d'un plot PD.

La porte 14b reçoit, d'une part, la sortie de la porte 12c et, d'autre part, à partir du même plot PD, le signal de programmation du Top 0.

La sortie de la porte OU 15 est finalement débitée sur la sortie To de Top 0 à travers un tampon 3 états 13d qui reçoit un signal de commande de sortie à partir du plot CB.

Sur les figures 5, 6 et 7 on a représenté les tables de vérité donnant respectivement les signaux de sortie de S1 et de S2 pour la figure 5, de To (Top 0) pour la figure 6 et de Ss pour la figure 7.

Sur la figure 5 les signaux de commande déclenchant la sortie de signaux sur S1 et S2 proviennent des plots PA, PB, PC, PD et PE, et, suivant que ces plots sont actionnés ou non, les sorties sur S1 et S2 sont différentes; l'actionnement est représenté par le chiffre "1", le non actionnement par le chiffre "0", et lorsqu'il est indifférent qu'un plot soit actionné ou non on a fait figurer la lettre X, les indications "1", "0" et "X" étant portées dans les colonnes correspondant aux plots PA, PB, PC, PD et PE.

Dans les colonnes des sorties S1 et S2 on a porté des chiffres de 1 à 14 pour représenter les voies V1 à V14 en utilisant les symboles classiques pour le "OU exclusif" et le ET (comme indiqué au bas de la planche comportant les figures 5 à 7) et par un surlignage pour la fonction inversion (porte NON).

Sur les figures 6 et 7 on a utilisé les mêmes symboles que sur la figure 5 pour les sorties To et Ss.

En définitive sur les tableaux des figures 5 à 7, qui font partie intégrante de la présente description (ils ont été illustrés en tant que figures uniquement pour des raisons pratiques), on peut lire quelles sont les voies ou combinaisons logiques de voies qui sont disponibles sur les sorties S1, S2, To et Ss suivant les plots PA, PB, PC, PD et PE actionnés, les signaux d'entrée 1 à 14 (des voies V1 à V14) qui apparaissent tels quels ou combinés sur les sorties précitées représentant la position relative du disque codé et du dispositif de lecture en relation avec la gravure du disque.

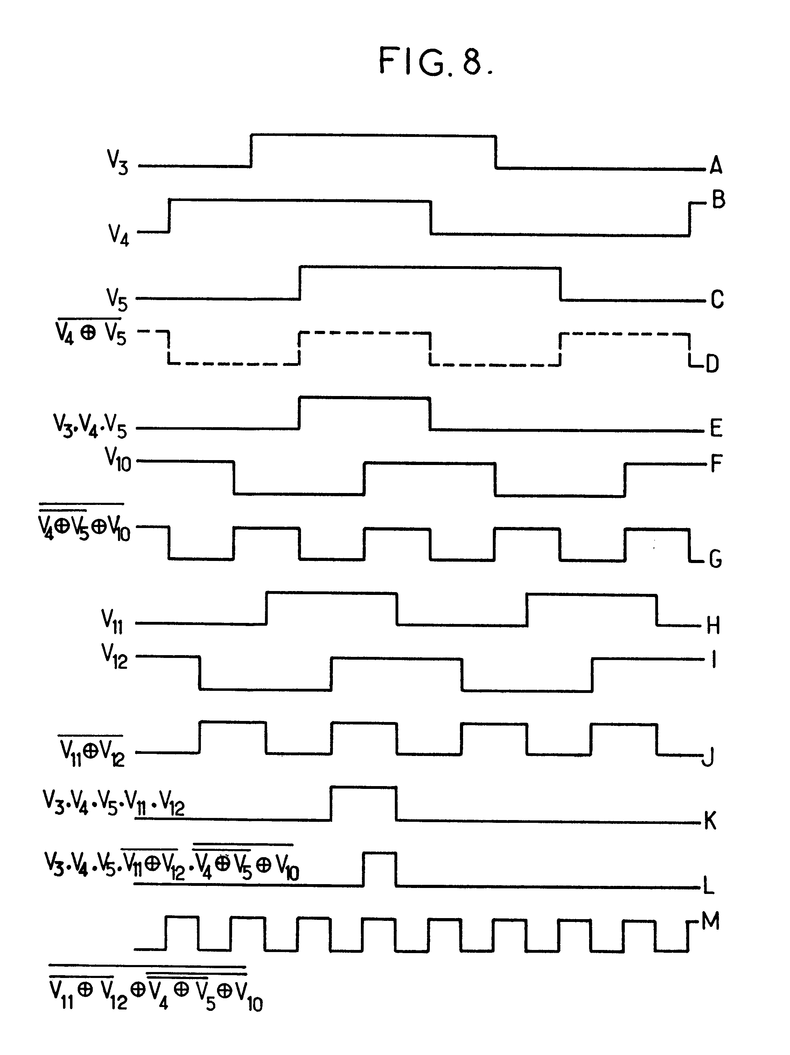

Sur la figure 8 on a représenté les signaux logiques sortant du système de lecture, d'une part (signaux A, B, C, F, H et I) et les signaux logiques obtenus par combinaisons logiques, d'autre part (signaux D, E, G, J, K, L et M).

Ces signaux A à M de la figure 8 sont constitués, à titre d'exemple, comme suit :

a) signaux logiques sortant du système de lecture

 - "A" : voie V3 avec un seul top par tour de 1/2.600ème;

 - "B" et "C" : respectivement voies V4 et V5 de 1250 périodes par tour, décalées de $\pi/2$;

 - "F" : voie V10 avec 2500 périodes par tour, décalée de $\pi/4$ par rapport à la voie V12 ("I");

 - "H" et "I" : respectivement voies V11 et V12 de 2500 périodes par tour, décalées de $\pi/2$;

b) signaux logiques obtenus par combinaisons logiques

 - "D" : signal de 2500 périodes par tour obtenu en combinant dans un circuit "OU exclusif inversé" (fonction coïncidence) les voies V4 et V5 ("B" et "C");

 - "E" : le top zéro pour 1250 périodes par tour est obtenu en combinant dans une porte ET les voies V3, V4 et V5 ("A", "B" et "C");

 - "G" : signal de 5000 périodes par tour obtenu en combinant le résultat "D" et la voie V10 ("F") dans un circuit "OU exclusif inversé";

 - "J" : signal de 5000 périodes par tour décalé de $\pi/2$ par rapport à "G", obtenu en combinant les voies V11 et V12 ("H" et "I") dans un circuit "OU exclusif inversé";

 - "K" : le top zéro pour 2500 périodes par tour est obtenu en combinant les voies V3, V4, V5, V11 et V12 ("A", "B", "C", "H", "I") dans une porte ET, ou, plus précisément le top 1250 périodes par tour "E" et les voies V11 et V12 dans une porte ET;

 - "L" : le top zéro pour 5000 périodes par tour est obtenu en combinant dans une porte ET le top 1250 périodes par tour "E" avec les deux signaux de 5000 périodes par tour "G" et "J";

 - "M" : signal de 10.000 périodes par tour obtenu en combinant les signaux 5000 périodes par tour "J" et "G" dans un circuit "OU exclusif inversé".

7

On voit donc qu'en fonction de la programmation des plots PA, PB, PC, PD, PE on peut obtenir sur les sorties S1, S2, Ss et To :
- 2 voies décalées de $\pi/2$ de 1250 périodes/tour ("B" et "C") avec Top zéro "E" calibré, sur S1, S2 et To;
- 2 voies décalées de $\pi/2$ de 2500 périodes/tour ("H" et "I") avec Top 0 "K" calibré, sur S1, S2 et To;
- 2 voies décalées de $\pi/2$ de 5000 périodes/tour ("G" et "J") avec Top 0 "L" calibré, sur S1, S2 et To; et
- 5000 périodes ou 10.000 périodes sur Ss, quel que soit le nombre de périodes sur S1 et S2 (cette voie, disponible en Ss, est particulièrement destinée à fournir une information tachymétrique, c'est-à-dire de vitesse).

Il en résule qu'on peut obtenir avec seulement six voies de lecture, pour un seul disque codé, des informations équivalentes à celles obtenues avec trois disques codés incrémentaux comportant au total 12 pistes (3 à 5 pistes pour chaque disque codé) et cela sans que l'on aie besoin de graver sur le disque une voie comportant plus de 2500 périodes.

Dans la pratique, on optimise l'utilisation des 14 voies (V1 à V14) du dispositif de lecure incrémental en tenant compte, d'une part, des limites de résolution pour une dimension donnée du disque codé et, d'autre part, des résolutions les plus demandées par l'utilisateur.

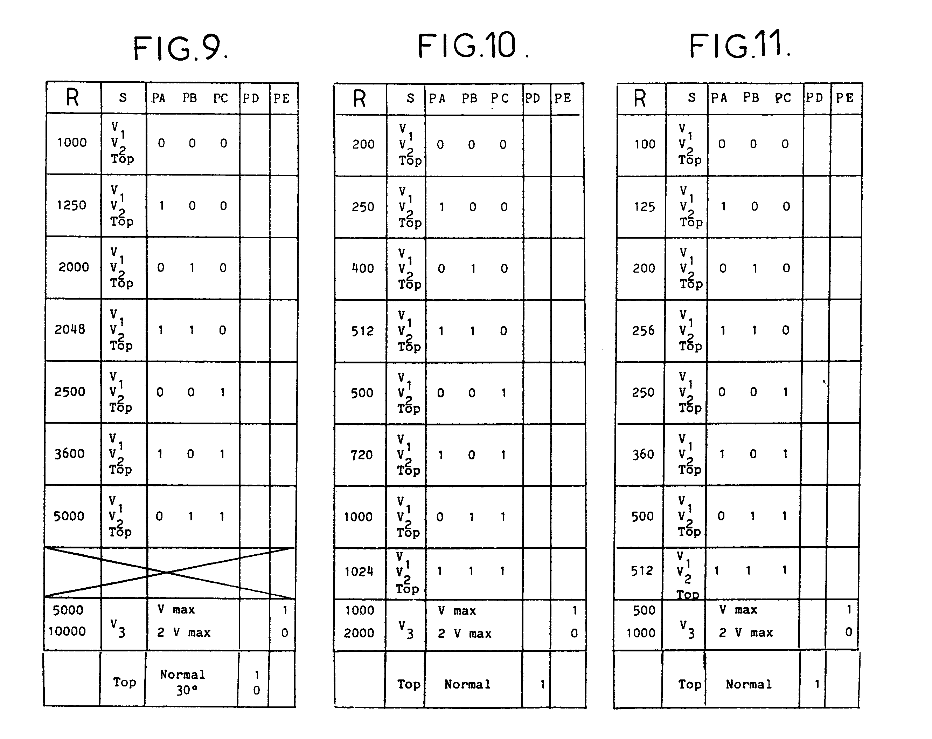

A titre d'exemple, les résolutions de trois disques codés ont été illustrées sur les figures 9, 10 et 11 en utilisant le même dispositif de lecture pour ces trois types de disques, les colonnes PA, PB, PC, PD, PE correspondant aux plots portant ces références et "1" indiquant l'actionnement et "0" le non actionnement du plot. Enfin la colonne R indique la résolution.

Sur la figure 9 on a illustré un disque codé n° I de taille 23 (ayant un diamètre de 58 mm) et présentant les résolutions de 1.000, 1.250, 2.000, 2.048, 2.500, 3.600 et 5.000 périodes par tour sur deux voies décalées de $\pi/2$ sur S1 est S2, un top calibré ou spécial (30°) sur To et 5.000 ou 10.000 périodes sur Ss. Il s'agit là d'un disque de taille 23 de haut de gamme.

Sur la figure 10 on a illustré un autre disque codé n° II de taille 23 (ayant un diamètre de 58 mm), mais de bas de gamme, avec les résolutions de 200, 250, 400, 512, 500, 720, 1.000 et 1.024 périodes par tour sur deux voies décalées de $\pi/2$ sur S1 et S2, un top calibré sur To et 1.000 ou 2.000 périodes par tour sur Ss.

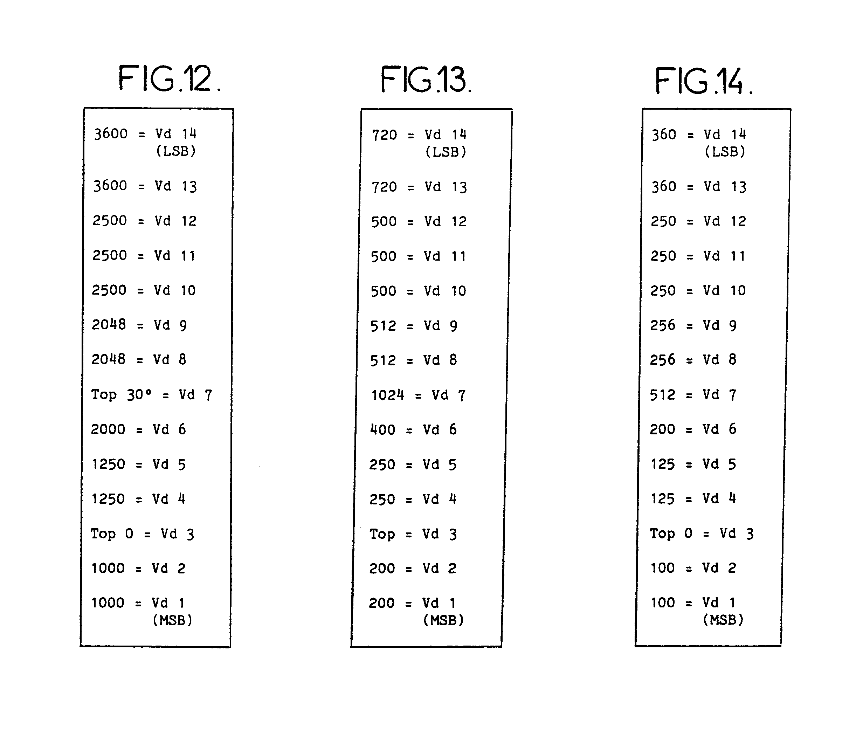

La figure 11 illustre un disque codé n° III de plus petite dimension, de taille 11 (ayant un diamètre de 27 mm), et ayant les résolutions de 100, 125, 200, 256, 250, 360, 500, 512 par tour sur deux voies décalées de $\pi/2$ sur S1 et S2, un top calibré sur To et 500 ou 1.000 périodes sur Ss.

Les figures 12, 13 et 14 indiquent la résolution et la position des différentes voies pour les disques n° I, II et III des figures 9, 10 et 11 respectivement, les voies sur les disques étant référencées Vd1, Vd2,... Vd13, Vd14.

L'ensemble de lecture proprement dit de la figure I fonctionne en coopération avec un seul émetteur de lumière, par exemple une diode AsGa fonctionnant dans le proche infrarouge et alimentée en courant par une simple résistance reliée à la tension Vcc; cette diode éclaire le circuit intégré de la figure 1 à travers une optique convenable et les zones transparentes du disque codé, le circuit intégré de la figure 1 étant protégé soit par un enrobage transparent à l'infrarouge, soit par mise dans un boîtier à fenêtre en verre.

Un circuit intégré selon la figure 1 a été effectivement réalisé en technologie CMOS sur une surface de silicium inférieure à 15 mm$^2$. Un tel circuit intégré permet la lecture de 100.000 périodes par seconde, la transmission s'effectuant à partir des étages de sortie S1, S2, Ss, To par les moyens habituels.

On voit donc que l'invention permet de réaliser un dispositif de lecture optique incrémental complètement intégré sur une ou éventuellement un petit nombre de puces avec un encombrement et un coût très réduits et avec une fiabilité et une sécurité très grandes. En outre le circuit peut réaliser des fonction supplémentaires, telles qu'une fonction de test du circuit, et aussi la détermination du sens et de la vitesse de rotation.

Le trés faible encombrement des deux voies et du top permet même de multiplier le nombre de voies intégrées sur un seul circuit pour obtenir dans un même appareil avec un seul type de disque codé et un seul dispositif de lecture proprement dit plusieurs résolutions différentes (7 ou 8 par exemple avec seulement 14 voies élémentaires de lecture.

Pour simplifier les connexions de sortie, on peut programmer simplement la résolution que l'on souhaite utiliser, celle-ci sera seule présente sur les étages de transmission des deux voies décalées d'un quart de période et du top.

Il résulte que l'on peut, avec un seul dispositif de lecture et avec un seul type de disque codé, offrir 7 ou 8 résolutions différentes (par exemple 5.000, 3.600, 2.500, 2.048, 2.000, 1.250, 1.000 périodes par tour sur deux voies et top calibré à chaque fois), d'où en particulier standardisation de la fabrication, simplification de la gestion du stock de la distribution, de la conception, de la maintenance.

La possibilité de choisir la résolution pour un disque codé déterminé, par simple programmation, a l'avantage de permettre de modifier cette résolution d'une manière aisée, par exemple en fonction d'essais préliminaires, sans avoir à changer de disque codé.

En outre on peut prévoir une géométrie des voies de lecture du dispositif qui vient d'être décrit identique à celle mise en oeuvre dans un dispositif de lecture absolue d'une code optique du type décrit dans la demande de brevet n° 85 09076 déposée par la demanderesse le 14 Juin 1985 pour "Dispositif de lecture de code optique, notamment du type entièrement intégré", avec une puce, ou éventuellement un nombre petit de puces, ayant les mêmes dimensions et les mêmes repères, et utiliser le même type de boîtier et le même système d'entraînement pour un dispositif selon l'invention et pour un dispositif selon la demande de brevet précitée.

L'intégration permet non seulement de proposer un choix de résolutions important, programmable avec un seul appareil, mais aussi de le faire dans des appareils de très faibles dimensions (taille 11 par exemple), impossibles à réaliser avec un autre technologie.

L'intérêt pour le constructeur est triple :

- il suffit d'avoir un seul disque, un seul réticule et un seul lecteur, d'où diminution des stocks de produits finis et de parties élémentaires;

- pour un disque codé donné, la différence entre un dispositif de lecture incrémental selon l'invention et un dispositif de lecture absolue selon la demande de brevet précitée réside exclusivement dans la gravure du disque codé et la puce du lecteur; toutes les autres pièces peuvent être identiques, d'où standardisation et diminution des stocks de matière première et d'en-cours;

- la gestion commerciale est simplifiée et les délais sont réduits.

L'intérêt pour l'utilisateur est aussi très grand car il suffit d'un seul modèle de disque du fait de la résolution programmable, d'où standardisation et diminution des stocks, sans compromis sur la résolution maintenance moins coûteuse; il en résulte finalement un meilleur service à moindre coût.

Un dispositif selon l'invention peut être appliqué particulièrement aux montages décrits dans les demandes de brevet français de la demanderesse n° 83 06482 déposée le 20 Avril 1984 et n° 84 10689 déposée le 5 Juillet 1984, ainsi que n° 84 19711 et n° 84 19713, ces deux dernières, déposées le 21 Décembre 1984, comportant chacune un lecteur opto-électronique 10 qui peut être réalisé comme décrit ci-dessus.

Comme il va de soi et comme il résulte d'ailleurs déjà de ce qui précède, l'invention ne se limite nullement à ceux de ses modes d'application et de réalisation qui ont été plus spécialement envisagés; elle en embrasse, au contraire, toutes les variantes.

## Revendications

1. Dispositif de lecture de code optique incrémental - destiné à coopérer avec un élément en mouvement relatif par rapport à ce dispositif de lecture et comportant une première série de n pistes codées avec une succession de zones élémentaires de deux types de retransmission de lumière reçue et une seconde série de n pistes, chacune de ces dernières pistes étant codée complémentairement à une des pistes de la première série -qui comprend

une source de lumière pour éclairer les pistes des deux séries, et

des moyens de détermination d'éclairement pour déterminer si de la lumière est ou non retransmise par une zone élémentaire observée de chacune des pistes,

ce dispositif de lecture étant caractérisé en ce que les moyens de détermination d'éclairement, qui sont portés par 1 à p puces (p étant un nombre entier petit), comportent en combinaison :

- d'une part, pour chacune des pistes de l'élément codé, une paire de photodiodes (2a, 2d), un amplificateur différentiel (3a, 3b, 6) dont les deux entrées reçoivent les signaux émis par les deux photodiodes, un trigger (7) donnant un front avant raide aux signaux reçus de la sortie de l'amplificateur différentiel; et

- d'autre part, un ensemble électronique (Z) à portes logiques (8, 9, 10, 11, 12, 14, 15) recevant les sorties desdits triggers (7) et débitant sur au moins trois sorties (S1, S2, To) les signaux représentatifs de position pour deux voies décalées de $\pi/2$ et un Top calibré.

2. Dispositif selon la revendication 1, caractérisé en ce que l'élément porteur de code est un disque et la lecture des zones opaques ou transparentes de celui-ci est effectuée par diascopie, c'est-à-dire par lumière transmise ou non transmise à travers les zones respectivement transparentes et opaques du disque.

3. Dispositif selon la revendication 1 ou 2, caractérisé en ce que l'amplificateur différentiel est constitué par deux amplificateurs (3a, 3b) en parallèle, recevant chacun la sortie d'une des deux photodiodes de la paire de photodiodes accouplées, et par un comparateur (6) dont les deux entrées (4a, 4b) reçoivent chacune la sortie d'un des deux amplificateurs précités, disposés en parallèle.

4. Dispositif selon l'une quelconque des revendications précédentes, caractérisé en ce qu'on prévoit un décalage d'amplitude (h), dans le basculement provoqué par la partie montante, d'une part, et la partie descendante, d'autre part, du signal sortant de l'amplificateur différentiel, c'est-à-dire une hystérésis du comparateur, dans le mode de réalisation préféré de cet amplificateur différentiel.

5. Dispositif selon l'une quelconque des revendications précédentes, caractérisé en ce que le dispositif de lecture comporte des moyens pour envoyer, sur les photodiodes ou les entrées des amplificateurs différentiels, des signaux aptes à simuler, sur la sortie des diodes ou l'entrée des amplificateurs respectivement, à volonté le niveau de bit "0" ou "1".

6. Dispositif selon l'une quelconque des revendications précédentes, caractérisé en ce que l'ensemble électronique de portes logiques débite également sur une quatrième sortie (Ss) un signal à fréquence maximale représentatif de la vitesse de déplacement relatif de l'élément en mouvement relatif par rapport au dispositif de lecture.

7. Dispositif selon l'une quelconque des revendications précédentes, caractérisé en ce que le dispositif de lecture comporte, d'une part, dans l'ensemble de portes électroniques, des portes supplémentaires permettant par combinaison logique d'engendrer des pistes fictives en plus des pistes prévues sur

**0 214 011**

l'élément en mouvement relatif, et, d'autre part, des moyens (PA, PB, PC) pour commander ces portes supplémentaires afin de rendre opérationnelles soit les pistes réelles de cet élément, soit des pistes fictives sélectionnées parmi les pistes fictives ainsi engendrables.

FIG.1..

FIG.2.

86401680 3

## FIG.3:

## FIG.4.

## FIG.5.

| PA | PB | PC | PD | PE | S1 | S2 |
|---|---|---|---|---|---|---|
| 0 | 0 | 0 | X | X | 1 | 2 |
| 1 | 0 | 0 | X | X | 4 | 5 |
| 0 | 1 | 0 | X | X | $\overline{1 \oplus 2}$ | 6 |
| 1 | 1 | 0 | X | X | 8 | 9 |
| 0 | 0 | 1 | X | X | 11 | 12 |
| 1 | 0 | 1 | X | X | 13 | $\overline{14}$ |
| 0 | 1 | 1 | X | X | $\overline{12 \oplus 11}$ | $\overline{4 \oplus 5 \oplus 10}$ |
| 1 | 1 | 1 | X | X | $\overline{9 \oplus 8}$ | 7 |

## FIG.6.

| PA | PB | PC | PD | PE | Top 0 (To) |
|---|---|---|---|---|---|
| 0 | 0 | 0 | 1 | X | 3.1.2. |
| 1 | 0 | 0 | 1 | X | 3.4.5. |
| 0 | 1 | 0 | 1 | X | 3.6. $\overline{(1 \oplus 2)}$ |
| 1 | 1 | 0 | 1 | X | 3.1.2.8.9. |
| 0 | 0 | 1 | 1 | X | 3.1.2.11.12 |
| 1 | 0 | 1 | 1 | X | 3.6. $\overline{(1 \oplus 2)}$.13.14 |
| 0 | 1 | 1 | 1 | X | 3.4.5. $\overline{(11 \oplus 12)}$ . $\overline{(4 \oplus 5 \oplus 10)}$ |
| 1 | 1 | 1 | 1 | X | 3.4.5. $\overline{(8 \oplus 9)}$.7 |
| X | X | X | 0 | X | 7 |

## FIG.7.

| PA | PB | PC | PD | PE | Ss |
|---|---|---|---|---|---|
| X | X | X | X | 0 | $\overline{11 \oplus 12} \oplus \overline{10 \oplus 5 \oplus \overline{4}}$ |
| X | X | X | X | 1 | $\overline{11 \oplus 12}$ |

$\oplus$   pour "OU exclusif"

.   pour "ET"

# FIG. 8.

86401680 3

$V_3$ — A

$V_4$ — B

$V_5$ — C

$\overline{V_4 \oplus V_5}$ — D

$V_3 \cdot V_4 \cdot V_5$ — E

$V_{10}$ — F

$\overline{\overline{V_4 \oplus V_5} \oplus V_{10}}$ — G

$V_{11}$ — H

$V_{12}$ — I

$\overline{V_{11} \oplus V_{12}}$ — J

$V_3 \cdot V_4 \cdot V_5 \cdot V_{11} \cdot V_{12}$ — K

$V_3 \cdot V_4 \cdot V_5 \cdot \overline{V_{11} \oplus V_{12}} \cdot \overline{\overline{V_4 \oplus V_5} \oplus V_{10}}$ — L

— M

$\overline{\overline{V_{11} \oplus V_{12}} \oplus \overline{\overline{V_4 \oplus V_5} \oplus V_{10}}}$

## FIG.9.

| R | S | PA | PB | PC | PD | PE |
|---|---|---|---|---|---|---|
| 1000 | $V_1$ $V_2$ Top | 0 | 0 | 0 | | |
| 1250 | $V_1$ $V_2$ Top | 1 | 0 | 0 | | |
| 2000 | $V_1$ $V_2$ Top | 0 | 1 | 0 | | |
| 2048 | $V_1$ $V_2$ Top | 1 | 1 | 0 | | |
| 2500 | $V_1$ $V_2$ Top | 0 | 0 | 1 | | |
| 3600 | $V_1$ $V_2$ Top | 1 | 0 | 1 | | |
| 5000 | $V_1$ $V_2$ Top | 0 | 1 | 1 | | |
| ✕ | | | | | | |
| 5000 / 10000 | $V_3$ | V max / 2 V max | | | | 1 / 0 |
| | Top | Normal 30° | | | 1 / 0 | |

## FIG.10.

| R | S | PA | PB | PC | PD | PE |
|---|---|---|---|---|---|---|
| 200 | $V_1$ $V_2$ Top | 0 | 0 | 0 | | |
| 250 | $V_1$ $V_2$ Top | 1 | 0 | 0 | | |
| 400 | $V_1$ $V_2$ Top | 0 | 1 | 0 | | |
| 512 | $V_1$ $V_2$ Top | 1 | 1 | 0 | | |
| 500 | $V_1$ $V_2$ Top | 0 | 0 | 1 | | |
| 720 | $V_1$ $V_2$ Top | 1 | 0 | 1 | | |
| 1000 | $V_1$ $V_2$ Top | 0 | 1 | 1 | | |
| 1024 | $V_1$ $V_2$ Top | 1 | 1 | 1 | | |
| 1000 / 2000 | $V_3$ | V max / 2 V max | | | | 1 / 0 |
| | Top | Normal | | | 1 | |

## FIG.11.

| R | S | PA | PB | PC | PD | PE |
|---|---|---|---|---|---|---|
| 100 | $V_1$ $V_2$ Top | 0 | 0 | 0 | | |
| 125 | $V_1$ $V_2$ Top | 1 | 0 | 0 | | |
| 200 | $V_1$ $V_2$ Top | 0 | 1 | 0 | | |
| 256 | $V_1$ $V_2$ Top | 1 | 1 | 0 | | |
| 250 | $V_1$ $V_2$ Top | 0 | 0 | 1 | | |
| 360 | $V_1$ $V_2$ Top | 1 | 0 | 1 | | |
| 500 | $V_1$ $V_2$ Top | 0 | 1 | 1 | | |
| 512 | $V_1$ $V_2$ Top | 1 | 1 | 1 | | |
| 500 / 1000 | $V_3$ | V max / 2 V max | | | | 1 / 0 |
| | Top | Normal | | | 1 | |

8640168 3

# FIG.12.

```
3600 = Vd 14
          (LSB)

3600 = Vd 13

2500 = Vd 12

2500 = Vd 11

2500 = Vd 10

2048 = Vd 9

2048 = Vd 8

Top 30° = Vd 7

2000 = Vd 6

1250 = Vd 5

1250 = Vd 4

Top 0 = Vd 3

1000 = Vd 2

1000 = Vd 1
          (MSB)
```

# FIG.13.

```
720 = Vd 14
          (LSB)

720 = Vd 13

500 = Vd 12

500 = Vd 11

500 = Vd 10

512 = Vd 9

512 = Vd 8

1024 = Vd 7

400 = Vd 6

250 = Vd 5

250 = Vd 4

Top = Vd 3

200 = Vd 2

200 = Vd 1
          (MSB)
```

# FIG.14.

```
360 = Vd 14
          (LSB)

360 = Vd 13

250 = Vd 12

250 = Vd 11

250 = Vd 10

256 = Vd 9

256 = Vd 8

512 = Vd 7

200 = Vd 6

125 = Vd 5

125 = Vd 4

Top 0 = Vd 3

100 = Vd 2

100 = Vd 1
          (MSB)
```

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | GB-A-2 149 096 (SHARP KABUSHIKI) <br> * Abrégé et figure 5 * | 1,2,5 | H 03 M 1/30 <br> G 01 D 5/245 |
| | --- | | |
| A | DE-A-2 721 136 (JENOPTIK) <br> * Pages 10-13; figures * | 1,2 | |
| | --- | | |
| A | GB-A-2 100 423 (ITEK) <br> * Page 3, ligne 34 - page 4, ligne 2; page 5, lignes 3-6; figures 5-10 * | 1,2 | |
| | --- | | |
| A | US-A-3 487 400 (LUDEWIG) <br><br> * Colonne 4, ligne 35 - colonne 8, ligne 9; figures 1-5 * | 1-3,5, 7 | |
| | --- | | |
| A | GB-A-2 067 747 (STANLEY TOOLS) <br><br> * Page 2, lignes 40-62; figures 1,2 * | | |
| | ----- | | |

**DOMAINES TECHNIQUES RECHERCHES (Int. Cl.4)**

H 03 M 1/30
G 01 D 5/245
G 01 D 5/34
G 01 D 5/34

Le présent rapport de recherche a été établi pour toutes les revendications

| Lieu de la recherche <br> LA HAYE | Date d'achèvement de la recherche <br> 14-11-1986 | Examinateur <br> GUIVOL Y. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03.82